Europäisches Patentamt

European Patent Office

Office européen des brevets

(19)

(11) Publication number: **0 035 841**

**A2**

(12) # EUROPEAN PATENT APPLICATION

(21) Application number: **81300750.7**

(22) Date of filing: **24.02.81**

(51) Int. Cl.³: **H 01 L 29/52**
     **H 01 L 29/743**

(30) Priority: **06.03.80 GB 8007619**

(43) Date of publication of application:
**16.09.81 Bulletin 81/37**

(84) Designated Contracting States:
**DE FR IT SE**

(71) Applicant: **WESTINGHOUSE BRAKE AND SIGNAL COMPANY LIMITED**
**Foundry Lane**
**Chippenham Wiltshire SN15 1RT(GB)**

(72) Inventor: **Bishop, Patrick Laurence Thomas**
**Westcode Semiconductors P.O. Box 57 Langley Road**
**Chippenham Wiltshire SN15 1LJ(GB)**

(72) Inventor: **Garrett, John Mansell**
**Westcode Semiconductors P.O. Box 57 Langley Road**
**Chippenham Wiltshire SN15 1JL(GB)**

(74) Representative: **Page, Edmund John**
**WESTINGHOUSE BRAKE AND SIGNAL COMPANY**
**LIMITED P.O.Box 85 Foundry Lane**
**Chippenham Wiltshire SN15 1RT(GB)**

(54) A shorted-emitter thyristor device.

(57) In a thyristor device (1) the dynamic characteristics, e.g. critical dV/dt, of the thyristor may be improved by means of shorts (2) between the base layer (4) and the emitter metallisation layer (9). Such shorts, however, slow the rate of conduction spreading. To overcome this the series resistance (Rs) of the shorts (2) is made at least equal to the maximum effective lateral resistance (Ra) of the base layer between the shorts (2) by means of a layer (7) of resistive material provided between the upper surface of the columns (3) of the shorts (2) and the emitter metallisation layer (9). The resistive material may be silicon of the same type as the base layer (4) but possessing higher resistivity or a cermet film. In another form in the upper surface of the columns (3) of the shorts (2), in contact with metallisation layer (9), a moat (13) surrounding a central land (12) is etched to leave only a relatively small contact area.

EP 0 035 841 A2

./...

Croydon Printing Company Ltd.

FIG. 3

## A shorted-emitter thyristor device

The invention relates to shorted-emitter thyristor devices.

It is well-known in the prior art to improve the dynamic characteristics of a semiconductor thyristor device by incorporating emitter shorts by means of which the thyristor base layer is directly connected to the emitter metallisation layer at a number of points distributed across the surface of the device. A shorted emitter construction of this type confers the advantages of improved critical dV/dt, temperature stability of the forward blocking capability and turn-off time.

However, a shorted-emitter construction has the disadvantage of slowing the rate of conduction spreading and increasing conduction losses, partly because of the loss of emitter area, due to perforation of the emitter layer by the shorting structure and partly because of severe reduction of carrier injection in a zone surrounding each short, particularly at low emitter current densities, due to the local discharge of bias across the emitter junction. The forward conducting voltage of the device is increased due to two factors; first, the partial discharge of the base layer lowers the forward bias or saturation level of the centre collecting junction and, secondly, the substantial restriction of carrier injection to a part only of the emitter results in the current density of the conducting part of the emitter being increased together with a corresponding increase in the ohmic losses due to bulk resistance of the silicon semiconductor material.

It is an object of the present invention to improve the efficiency of a shorted emitter thyristor device to ensure that the emitter current density during conduction is as uniform as possible.

According to the present invention, there is provided a shorted-emitter thyristor device comprising a plurality of superimposed semiconductor layers of alternating conductivity type including an emitter end layer and an adjacent base layer, the emitter layer having formed therein a plurality of perforations through each of which extends a column of base layer material to make ohmic contact with a metallisation layer on the end surface of the emitter layer constituting a short between the base layer and the emitter metallisation layer, and wherein the series resistance of the short is at least equal to the maximum effective lateral resistance of the base layer between said shorts.

In one form of the invention the short makes ohmic contact with the metallisation layer through a further layer of resistive material.

For a better understanding of the present invention and to show how it may be carried into practice, reference will now be made by way of example only, to the accompany-

ing drawings, wherein:-

Fig. 1 is a schematic illustration of a section through a shorted-emitter thyrsitor,

Figs. 2(a) - (f) schematically illustrate steps in a first method of forming an emitter short series resistance,

Figs. 3(a) - (e) schematically illustrate steps in a second method of forming an emitter short series resistance,

Figs. 4(a) and 4(b) schematically illustrate sections through thyristors with alternative emitter short series resistance constructions,

Figs. 5(a) - (d) schematically illustrates, along the section XXX of Fig. 4(b), four steps in one method of forming the series resistance construction of Fig. 4(b),

Fig. 6 schematically illustrates a section through a thyristor having a further alternative emitter short series resistance construction, and

Figs. 7(a) - (c) schematically illustrate steps of a still further method of forming the emitter short series resistances.

In order for an emitter short to be effective, the lateral resistance in the p-base layer between any part of the emitter and the body of a short must have a low value. On the other hand, for the conduction property not to be unduly impaired, the lateral resistance should have a relatively high value. Furthermore, the effective value of the lateral resistance should ideally be the same for all points in the emitter layer.

The practical approach is a compromise at which the base layer has the highest value of resistance which will permit either the desired dV/dt or the desired turn-off performance to be achieved.

Theoretically, therefore, an efficient shorted-emitter thyristor structure might be expected to possess zero p-base resistance (disregarding the effect of this on emitter injection efficiency) and a series resistance in the electrical path between the short and the emitter electrode. In practice, this type of structure should be closely approached if the distributed p-base resistance is as low as possible and a relatively large resistance is contained within the structure of the emitter short itself.

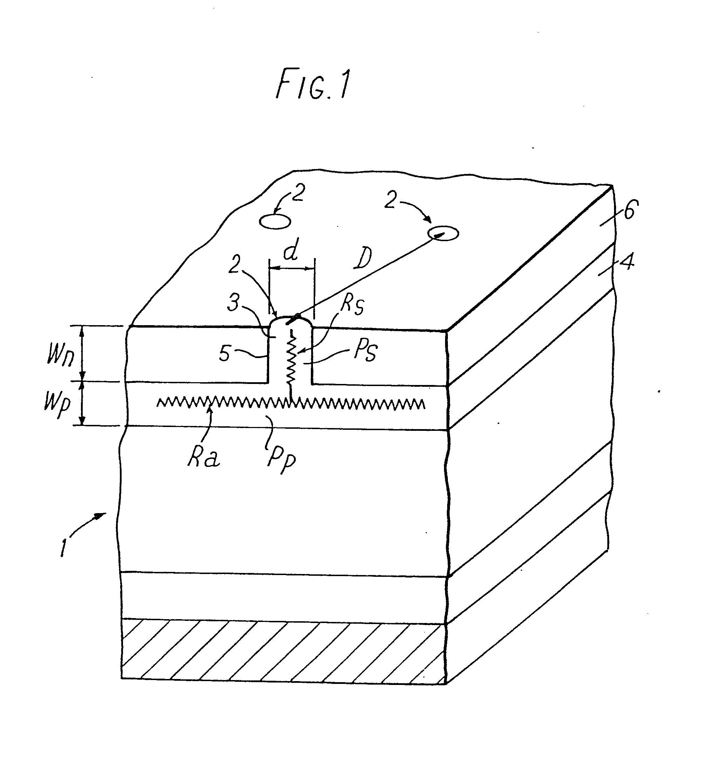

Referring now to the drawings, Fig. 1 shows a section through a thyristor 1 having a shorted emitter construction. The shorts 2 comprise columns 3 or p-type semiconductor material rising from the p-type base layer 4 through perforations 5 in the overlying n-type emitter layer 6. The shorts are circular in section, having diameter $\underline{d}$, and are arranged in a regular triangular array over the whole surface of the device, with an inter-short spacing D.

It can be shown in a device of the type illustrated with the form of short configuration shown, that the effective distributed lateral base resistance is closely approximated by: -

$$Ra = \frac{Pp}{4\pi Wp} \left( 2 \ln \frac{D}{d} + \left(\frac{d}{D}\right)^2 - 1 \right),$$

where    Ra = distributed lateral base resistance at maximum inter-short distance, D = inter-short spacing, d = short diameter, Pp = mean resistivity of p-type base layer, and Wp = depth of p-type base layer, and, the short series resistance is: -

$$Rs = \frac{4\ Ps\ Wn}{\pi\ d^2},$$

where    Rs = emitter short series resistance, Ps = mean resistivity of p-type material in column of the short, and Wn = depth of n-type emitter layer.

The total short resistance R short is thus the sum of these two expressions, i.e.

R short = Ra + Rs.

In an embodiment of the present invention, it is an object to produce Rs $\geqq$ Ra and to provide the required short series resistance by ensuring that all of the shorts have the same nominal diameter, $\underline{d}$, calculated according to the above expressions.

In a typical device of the above type, having a total shorted emitter surface area of 2% of total emitter area,

$$\frac{D}{d} = 7 \text{ approximately,}$$

so that
$$d \leqslant 2.36 \sqrt{\frac{Ps}{Pp}} \cdot Wn\, Wp.$$

In another device in which the area of shorts is 10% of total emitter area,

$$d \leqslant 3.38 \sqrt{\frac{Ps}{Pp}} \cdot Wn\, Wp.$$

The factor $\frac{Ps}{Pp}$ in most semiconductor examples has a value of approximately 0.3, thus, to a further approximation the expression for the short diameter simplifies to: -

$$d \leqslant \sqrt{Wn\, Wp.}$$

For the sake of further example, if typical values of depths of n-type emitter layer, Wn, and p-type base layer, Wp, are 20 μm and 40 μm respectively, then for a device of total surface area of 1,000 mm$^2$, containing 29,000 shorts at an inter-short spacing, $\underline{D}$, of 200 μm the short diameter, $\underline{d}$, calculated according to the above expression must not be greater than 28 um.

If a device such as this is to achieve its design performance, each one of the shorts must be correctly formed and all of the shorts 2 must be substantially the same. Whilst such devices, for example, of the type shown in Fig. 1, may be produced by existing production methods, there are a number of limitations thereby imposed in the exploitation of the advantages of the invention.

For instance, in the above example, the large number and small diameter $\underline{d}$ of the shorts 2 presents a formidable inspection task. Furthermore, as the short spacing $\underline{D}$ increases the criterion $Rs \ggg Ra$ can only be realised by further reducing the short diameter $\underline{d}$ resulting in a generally inefficient shorting effect. In constructions according to the invention the shorts have an increased resistance such that $Rs \gg Ra$.

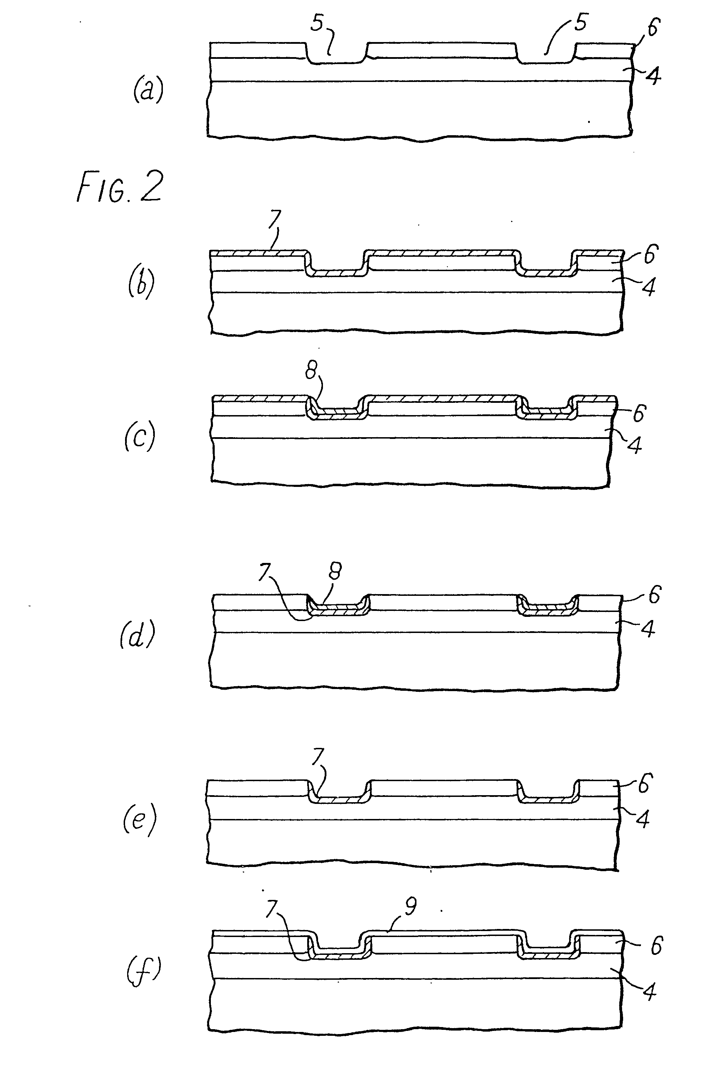

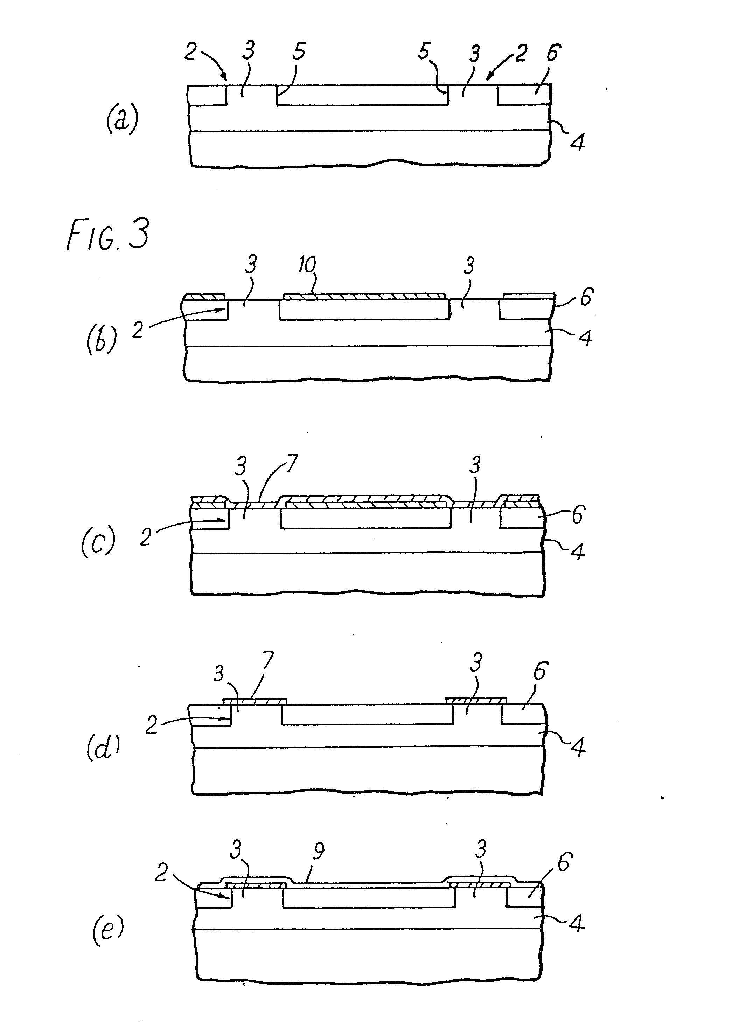

Figs. 2 and 3 show two practical alternative forms of device in which a resistive film 7 is deposited in with each perforation 5 of a conventional thyristor device in order to provide shorts having inherent resistances. Referring now to the steps (a) to (f) of Fig. 2, in the first step (a), a perforation 5 is formed at the location of each emitter short by means of a chemical etching process through the phosphorus n-diffusion layer of the thyristor emitter 6. In this step of forming the perforations 5, the remaining surface of the emitter 6 may be screened by a mask (not shown) to confine the action of the chemical etch to the perforation area itself.

In the next step (b), after removing any mask, a resistive film 7 is formed over the whole upper surface of the silicon wafer. Preferably, the resistive material has a nearly constant resistivity, or is of a type having a negative temperature co-efficient of resistivity. This latter type of resistive film would permit the degree of shorting employed to automatically adjust for the deterioration of thyristor characteristics with increasing temperature. The well of the perforation is next at least partially filled with a mask 8 as in step (c) to protect the resistive film 7 in the perforation 5 during a subsequent etching process to remove the resistive film 7 from the upper surface of the emitter, as shown at step (d). The perforation mask 8 is then removed, as shown in step (e), and a low resistance metallic contact layer 9 is deposited over the whole cathode face including in the perforations as shown in step (f). It will be noted in step (e) of Fig. 2, that the resistive film 7 on the cylindrical wall of the perforation 5 extends above the level of the p-type material of the base layer 4 and onto the n-type material of the emitter 6 so as to prevent the final metallic contact of (f) making direct ohmic contact with the surface of the p-base layer 4 in the well of the perforations 5.

Fig. 3 shows a method alternative to that of Fig. 2, in step (a) the emitter shorts 2 are shown as columns 3 of p-type material extending through the n-type emitter layer 6 to the surface of the silicon wafer. In the next step, a mask 10 is applied over most of the emitter surface leaving exposed only the perforations 5 themselves and a small peripheral region of the emitter. In the next stage (c), a resistive film 7 is deposited over the whole surface of the masked silicon wafer and in the following stage (d), the unwanted portion of the resistive film 7 and the mask 10, i.e. that over the emitter regions, is removed by partly mechanical abrasion of the highest standing parts of the resistive film over the emitter areas and subsequent chemical etch to remove the mask 10. In this method also the resistive film 7 extends beyond the perimeter of the shorts 2 to prevent direct contact between the low resistance metallic contact layer deposited in the next step (e) and the surface of the shorts themselves.

In one example of a device of the type being described, the resistive film 7 may be provided by an overlying layer of polycrystalline or epitaxial silicon of the same type as the base region 4 but having a higher resistivity and of a chosen thickness sufficient to give the desired value of resistance Rs.

Alternatively, the resistive film 7 may be provided by a deposited cermet film, which is a microscopic mixture (dispersion) of conducting and insulating regions, comprising silicon dioxide or like insulator doped with a metal conductor. The metallic component of the cermet is selected to give the desired temperature co-efficient of resistivity, e.g. gold-$SiO_2$ or gold-$Ta_2O_5$ cermet films which have strong negative co-efficients, stainless

steel-$SiO_2$ has a practically constant resistivity, i.e. a very small temperature co-efficient.  The resistivity of a cermet film may be varied over a wide range by adjustment of the concentration of the metallic conductor component.

A cermet  film may be applied selectively by printing, e.g. silk-screen printing, or by co-sputtering techniques which are known in the art.  See, for example, reference articles: (1) Co-Sputtered Cermet Films, Sprague Electric Research and Development Paper RDP-67-1, Sprague Electric Company, North Adams, Massachusetts, August 1967.
(2) Electrical properties of Sputtered Au/$Ta_2O_5$ cermet thin films, Sashital and Packswer, Journal of Vacuum Science and Technology, Volume 9, Number 1, January 1972.

There is a particular advantage in employing a resistive film having a negative temperature co-efficient of resistivity since this  tends to compensate for the temperature co-efficient of the distributed component of base resistance, Ra, which is naturally positive.  This is desirable so as to achieve better conformity of shorting efficiency with temperature, so that the total effective resistance, Ra + Rs can vary in proportion to the injecting voltage of the emitter junction which at moderate cermet densities is known to fall with temperature. It follows therefore that the temperature co-efficient of Rs may be chosen so that the same value of Ra + Rs has a negative overall temperature co-efficient, notwithstanding the positive temperature co-efficient of Ra.

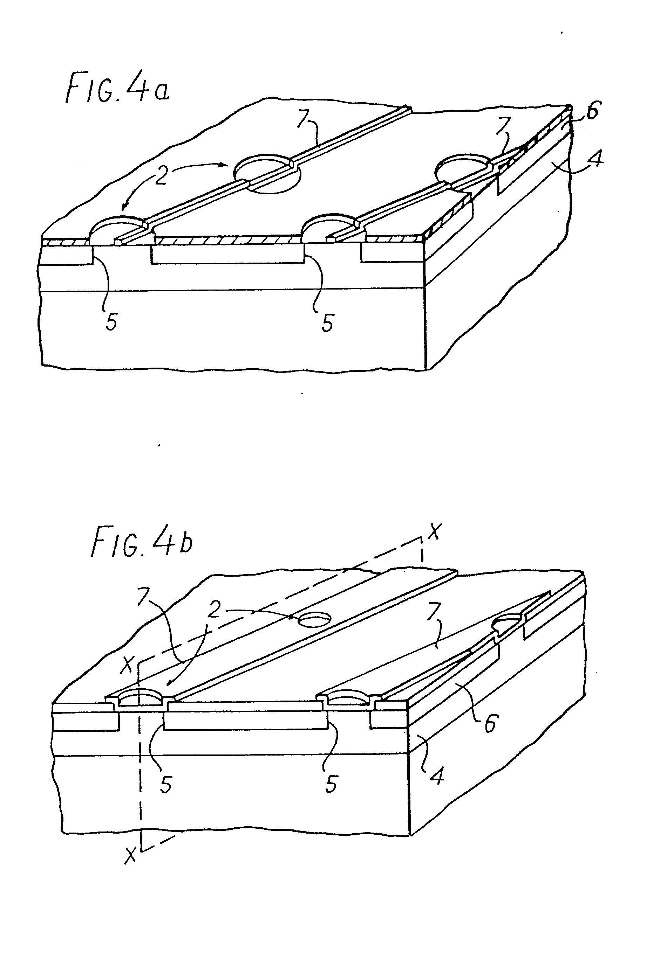

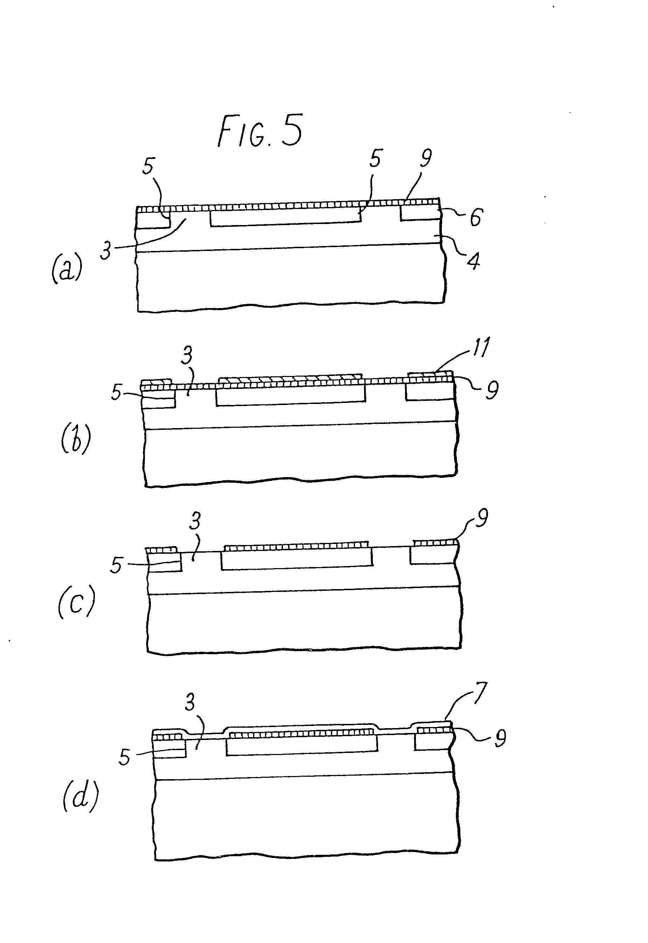

Alternative configurations of series resistance components in the shorting paths are shown in Figs. 4(a) and 4(b), which show alternative degrees of contact between the resistive film 7 and the surface of the perforations 5. In both these examples, the resistive film 7 is deposited in the form of rectilinear strips running along rows of emitter shorts 2 either partly, or wholly, covering them. In this arrangement, the strips of resistive film 7 are applied over the surface of the main metallised emitter contact 9. One method of applying these resistive film strips 7 is shown in Fig. 5(a) - (d). Fig. 5(a) shows a section through part of a thyristor silicon wafer, such as section XXX in Fig. 4(b) in which the emitter shorts 2 are shown as columns 3 of p-type base 4 material rising through perforations 5 in the n-type emitter layer 6. In Fig. 5(b), a mask 11 is applied to the upper surface of the emitter contact layer 9 to expose metal areas which are to be replaced by resistive film 7 in direct contact with the top surfaces of the columns 3.

In the next step (c), the exposed areas are etched to remove the metal cathode contact layer 9 and in the next step (d), the resistive film 7 is deposited in strips over the surface of the emitter metallisation layer 9 and the exposed surface of the columns 3.

As previously mentioned in connection with Figs. 2 and 3, the area of metallisation removed extends marginally beyond the perimeter of the perforations 5 in order to prevent the final metallic contact making direct connecttion with the p-base material in the column 3 of the short 2.

The deposited resistive layers described above in Figs. 2 to 5, may comprise an homogeneous layer or, alternatively, a composite layer comprising a first layer chosen for relieable contact with the surface of the silicon in the region of the emitter shorts and an overlying second, probably thicker, layer of material chosen preferentially for its resistance characteristics. In such a composite layer arrangement, the first layer must be sufficiently thin and have sufficient resistivity not to form a significant electrical bridge between the n-type emitter layer and the p-type emitter short.

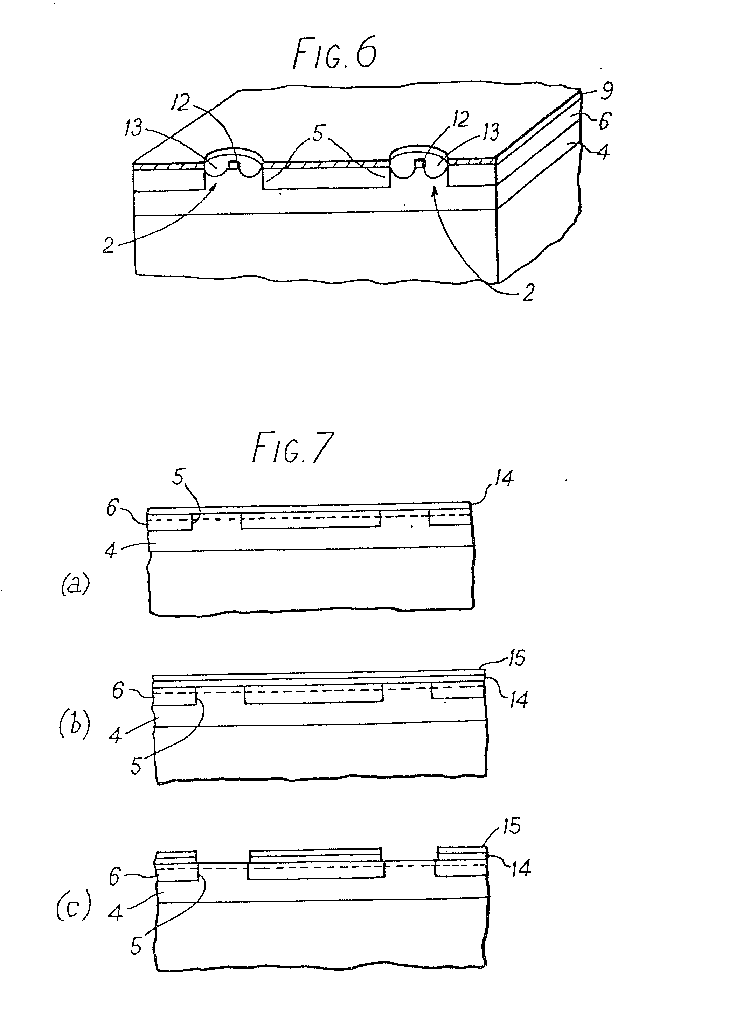

In the arrangement of Fig. 6 the series resistance of a short is substantially determined by a region of reduced lateral cross-section, in which a small area of metallisation, which itself has no significant resistance, applied to a small land 12 on the surface of the emitter short 2 exposed through a perforation 5. This arrangement relies, in operation, upon the size of the small metal contact having a spreading resistance which may be enhanced, as shown in the drawing, by etching a surrounding moat 13 or the like relatively lowered region in the silicon surface of the emitter short. In a typical example, the conductivity of the silicon in the perforation 5, as a result of dopant surface diffusion, is graduated from its highest value at the surface to decreasing values with increasing depth. In an assembled device of this type, ohmic contact between the metallic contacts of the emitter short 2 and the emitter contact 9 may be provided by a pressure electrode incorporated in the final encapsulation.

In a still further alternative arrangement of the invention shown in Fig. 7(a) - (c), a thin metallic film 14 is sintered onto the whole surface of a conventionally formed thyristor silicon wafer, as shown in (a). Subsequently, a thicker metallic film 15 is deposited over this surface, which film may be of a different material to that of the sintered film, as shown in (b). In the next stage, a mask is applied to the surface in register with the emitter short array and which leaves exposed the metallic film overlying the emitter shorts and the perimeter of the surrounding emitter layer. The thick metallic layer 15, together with any unsintered remaining thin metallic layer 14, is then selectively removed to expose the whole of the perforations which thereby provide a series resistance dependent on the resistance of the sintered surface region bridging the junction between the exposed p-type base layer and the n-type diffused emitter layer.

The invention has been described with reference to p-gate triode thyristors with shorting of the n-type emitter. It will be immediately appreciated by those skilled in the art to be equally applicable to similar four or five layer devices in which the material type has been transposed p for n and vice versa, and the shunting is applied to the p-type (anode) emitter.

0035841

CLAIMS:

1.  A shorted-emitter thyristor device (1) comprising a plurality of superimposed semiconductor layers of alternating conductivity type including an emitter end layer (6) and an adjacent base layer (4), the emitter layer (6) having formed therein a plurality of perforations (5) through each of which extends a column (3) of base layer (4) material to make ohmic contact with a metallisation layer (9) on the end surface of the emitter layer (6) constituting a short (2) between the base layer (4) and the emitter metallisation layer (9) characterised in that the series resistance (Rs) of the short (2) is at lease equal to the maximum effective lateral resistance (Ra) of the base layer (4) between said shorts (2).

2.  A thyristor device according to Claim 1 wherein the short (2) makes ohmic contact with the metallisation layer (9) through a further layer of resistive material (7).

3.  A thyristor device according to Claim 2 wherein the resistive material (7) comprises silicon of the same type as the base region (4) and of a relatively higher resistivity.

4.  A thyristor device according to Claim 2 wherein the resistive material (7) comprises a cermet film of silicon dioxide or the like doped with a metallic conductor.

5.  A thyristor device according to Claim 2 wherein the layer of resistive material (7) comprises a layer of metal sintered into the end surface of the emitter layer (6) including the shorts (2) and the metallisation layer (9) is absent from a region overlaying a short (2) and its immediate vicinity.

6.  A thyristor device according to any of Claims 2,3 or 4 or 5 wherein the resistive material (7) possesses a negative coefficient of resistivity.

7.  A thyristor device according to any of Claims 2 to 6 wherein the layer of resistive material (7) is deposited in rectilinear strips to intersect a plurality of shorts (2).

8.  A thyristor device according to any of Claims 2 to 7 wherein the layer of resistive material (7) comprises a composite layer of a first preferred ohmic contact material and a second preferred resistive material.

9.  A thyristor device according to Claim 1 wherein the column (3) of material comprising a short (2) has a region (12) of reduced lateral cross-section whereby substantially to determine the series resistance of the short (2).

10. A thyristor device according to Claim 9 wherein the region (12) of reduced cross-section is in ohmic contact with the metallisation layer (9).

11. A thyristor device according to Claim 10 wherein said region (12) of reduced cross-section comprises a land (12) in ohmic contact with the metallisation layer and surrounded by a relatively lowered region (13).

FIG.1

FIG.2

FIG.3

(a)

(b)

(c)

(d)

(e)

FIG. 4a

FIG. 4b

FIG. 5

(a)

(b)

(c)

(d)

## FIG. 6

## FIG. 7

(a)

(b)

(c)